# EUROPÄISCHE PATENTSCHRIFT

(11) **EP 2 305 017 B1**
(45) Veröffentlichungstag und Bekanntmachung des Hinweises auf die Patenterteilung: **17.02.2016**
(21) Anmeldenummer: 09779812.8
(22) Anmeldetag: 17.06.2009
(51) Int. Cl.: H05K 7/20

(54) **VERBESSERTE WÄRMEABFUHR AUS EINEM STEUERGERÄT**
IMPROVED HEAT DISSIPATION FROM A CONTROL UNIT
DISSIPATION THERMIQUE AMELIOREE D'UN APPAREIL DE COMMANDE

(30) Priorität: 17.07.2008 DE 102008040501
(43) Veröffentlichungstag der Anmeldung: 06.04.2011
(73) Patentinhaber: Robert Bosch GmbH, 70442 Stuttgart (DE)
(72) Erfinder: LISCHECK, Andre, 71665 Vaihingen/Enz (DE); WIESA, Thomas, 71665 Vaihingen (DE)
(86) Internationale Anmeldenummer: PCT/EP2009/057524
(87) Internationale Veröffentlichungsnummer: WO 2010/006869

(56) Entgegenhaltungen:
- WO-A1-01/58231
- WO-A2-2006/109206
- US-B1- 6 392 890

## Beschreibung

Die Erfindung betrifft ein Steuergerät, insbesondere für ein Kraftfahrzeug, wobei das Steuergerät ein mindestens einen Wärmeableitbereich aufweisendes Gehäuse besitzt, in dem mindestens eine elektrische und/oder elektronische Baugruppe angeordnet ist, die mindestens ein Wärmeableitelement aufweist.

### Stand der Technik

Die DE 101 41 697 beschreibt ein Steuergerät mit einer Leiterplatte die ein wärmeabgebendes elektrisches Bauelement aufweist. Das elektrische Bauelement wird gekühlt, indem es seine Wärme an ein die Leiterplatte umgebendes Gehäuse abgeben kann. Zu diesem Zweck ist das Gehäuse mit einem Bereich versehen, der in der Lage ist, Wärme abzuleiten. Um eine Wärmeableitung zu erreichen, wird die Leiterplatte mit dem wärmeleitenden Bereich in Berührungskontakt gesetzt.

Bei einem derartigen Berührkontakt können undefinierte Luftspalte zwischen der Leiterplatte und dem Gehäuse entstehen, wodurch eine optimale wärmeleittechnische Verbindung verhindert wird.

Die US 6392 890 B1 beschreibt ein Steuergerät nach dem Oberbegriff des Anspruchs 1.

### Offenbarung der Erfindung

Erfindungsgemäß ist vorgesehen, dass das Wärmeableitelement mit dem Wärmeableitbereich mittels eines in das Innere des Gehäuses durch mindestens einen Gehäusedurchbruch eingebrachtes, zumindest beim Einbringen pastöses Wärmeleitmedium wärmeleittechnisch verbunden ist. Dadurch wird erreicht, dass ein Luftspalt oder ein Raum zwischen dem Wärmeableitelement und dem Wärmeableitbereich ausgefüllt ist. Dies begründet eine optimale wärmeleittechnische Verbindung zwischen der Baugruppe und dem Gehäuse. Aufgrund des Gehäusedurchbruchs ist es möglich, das Wärmeleitmedium an Stellen innerhalb des Gehäuses einzubringen, die von außen während einer Herstellung nur schwer zu erreichen sind. Die Ausgestaltung des Gehäusedurchbruchs ist abhängig von dem verwendeten Wärmeleitmedium sowie der Geometrie des Wärmeableitelements und des Wärmeableitbereichs. Denkbar ist insbesondere ein kreisförmiger Gehäusedurchbruch oder ein langlochförmiger Gehäusedurchbruch. Ferner kann vorgesehen sein, dass das pastöse Wärmeleitmedium nach dem Einbringen aushärtet, sodass der Gehäusedurchbruch dicht verschlossen wird. Auf diese Weise ist es möglich die Vorteile der Erfindung in einem abgedichteten Gehäusekonzept für das Steuergerät zu realisieren. Zudem bringt die Verwendung des pastösen Wärmeleitmediums den Vorteil mit sich, dass sowohl kleine Luftspalte sowie größere Beabstandungen zwischen dem Wärmeableitelement und dem Wärmeableitbereich ausgefüllt und somit wärmeleittechnisch optimal überwunden werden können. Die Folge ist eine hohe Flexibilität bei einer Konstruktion und der Herstellung des Steuergeräts unter Beibehaltung der optimalen wärmeleittechnischen Verbindung.

Nach einer Weiterbildung der Erfindung ist vorgesehen, dass das Wärmeleitmedium einen zwischen dem Wärmeableitelement und dem Wärmeableitbereich liegenden, einen Anteil des freien Gehäuseinnenraums bildenden Spaltraum ausfüllt. Das Wärmeleitmedium ist nur lokal, das heißt nur bereichsweise, im Inneren des Gehäuses angeordnet und füllt nicht den gesamten Gehäuseinnenraum aus. Die lokale Anordnung des Wärmeleitmediums ermöglicht eine schnelle, effiziente und recourcensparende Umsetzung einer optimalen Wärmeableitung bei einer Herstellung des Steuergeräts.

Erfindungsgemäß ist weiter vorgesehen, dass das Gehäuse ein Einschubgehäuse ist, in das die Baugruppe eingeschoben ist. In diesem Fall ist vorgesehen, dass die Baugruppe bei der Herstellung in das Einschubgehäuse eingeschoben wird. Ein Einschieben des Einschubgehäuses in eine entsprechende Einrichtung ist nicht vorgesehen. Da es bei einem Einschubgehäuse besonders schwierig ist, eine optimale wärmetechnische Verbindung zwischen der eingeschobenen Baugruppe und dem Gehäuse herzustellen ist die Erfindung hier von besonderem Vorteil. Dies begründet sich darauf, dass nach einem Einschieben der Baugruppe weder überprüft werden kann, ob das Wärmeableitelement optimal mit dem Wärmeableitbereich in Berührkontakt steht. Ein Einbringen des pastösen Wärmeleitmediums vor dem Einschieben der Baugruppe führt dazu, dass bei dem Einschieben der Baugruppe das Wärmeleitmedium durch das Gehäuse und/oder die Baugruppe verschoben wird, wodurch die Qualität der wärmeleittechnischen Verbindung beeinträchtigt ist. Ein Einbringen des Wärmeleitmediums nach dem Einschieben der Baugruppe ist häufig nicht mehr möglich, da die Baugruppe typischerweise einen Gehäuseverschluss aufweist, der sich beim Einschieben der Baugruppe mit dem Gehäuse verbindet, und das Gehäuse verschließt. Die Erfindung ermöglicht auch bei dem Einschubgehäuse eine optimale wärmeleittechnische Verbindung herzustellen.

Erfindungsgemäß ist weiter vorgesehen, dass das Steuergerät für das Einschieben der Baugruppe eine Führung aufweist. Die Verwendung einer Führung ermöglicht es, die Baugruppe einfach und sicher in das Gehäuse einzuschieben und die Baugruppe innerhalb des Einschubgehäuses zu fixieren und abzustützen.

Erfindungsgemäß ist weiter vorgesehen, dass sich das Wärmeableitelement bis in die Führung erstreckt. Diese Weiterbildung ermöglicht es, dass Wärme von der Baugruppe über das Wärmeableitelement mittels der Führung an den Wärmeableitbereich des Gehäuses weitergeführt wird. Nach einer Weiterbildung der Erfindung ist vorgesehen, dass die Führung in der Zone des Wärmeableitbereichs liegt. Dies ermöglicht ein direktes Ableiten der Wärme in die Führungen.

Erfindungsgemäß ist weiter vorgesehen, dass die Führung als Führungsrinne ausgebildet ist. Die Führungsrinne besitzt vorzugsweise einen U-förmigen Querschnitt und umschließt das Bauelement somit zumindest bereichsweise von drei Seiten, wodurch es in drei Richtungen abgestützt und gesichert ist.

Nach einer Weiterbildung der Erfindung ist vorgesehen, dass ein Abschnitt des Gehäuses die Führungsrinne bildet. In dieser Ausgestaltung ist es besonders vorteilhaft, dass keine gesonderte Führungsrinne in das Gehäuse eingebracht werden muss, sondern das Einschubgehäuse so ausgestaltet ist, dass es, selbst die Führungsrinne ausbildet. Beispielsweise können hierfür entsprechende Wandungsverläufe des Gehäuses vorgesehen sein, die die Führungsrinne ausbilden.

Erfindungsgemäß ist weiter vorgesehen, dass die Führungsrinne mit mindestens einer Einprägung zum randseitigen Einklemmen der Baugruppe versehen ist. Durch das Einprägen der Führungsrinne, wird das Bauelement innerhalb der Führungsrinne eingeklemmt und fixiert. Dabei entsteht eine gute Wärmeableitung aufgrund eines verstärkten Berührkontakts, die durch Einbringen des Wärmeleitmediums optimiert wird.

Nach einer Weiterbildung der Erfindung ist vorgesehen, dass die Baugruppe eine Leiterplatte aufweist, die in der Führungsrinne aufgenommen wird. Die Ausgestaltung der Baugruppe als Leiterplatte ermöglicht ein einfaches Führen der Baugruppe mittels der Führung. Dabei kann insbesondere vorgesehen sein, dass auf der Leiterplatte Wärmeableitelemente angeordnet sind, die eine Flächengestalt aufweisen.

Die Erfindung betrifft ferner ein Verfahren zur Herstellung eines Steuergeräts, insbesondere nach der vorangegangenen Beschreibung, insbesondere für ein Kraftfahrzeug, wobei das Steuergerät ein mindestens einen Wärmeableitbereich aufweisendes Gehäuses besitzt, in dem mindestens eine elektrische und/oder elektronische Baugruppe angeordnet ist, die mindestens ein Wärmeableitelement aufweist, wobei das Wärmeableitelement mit dem Wärmeableitbereich mittels eines in das Innere des Gehäuses durch mindestens einen Gehäusedurchbruch eingebrachtes, zumindest beim Einbringen pastöses Wärmeleitmedium wärmeleittechnisch verbunden wird.

### Kurze Beschreibung der Zeichnungen

Die Zeichnungen veranschaulichen die Erfindung anhand von Ausführungsbeispielen, und zwar zeigt:
- Figur 1: ein Steuergerät mit Einschubgehäuse,
- Figur 2: eine Baugruppe in Form einer Leiterplatte,
- Figur 3: ein vereinfachter Ausschnitt eines Querschnitts des Steuergeräts,
- Figur 4: einen weiteren Ausschnitt des Querschnitts des Steuergeräts mit eingebrachtem Wärmeleitmedium,
- Figur 5: einen Ausschnitt eines Querschnitts eines weiteren Steuergeräts vor einem Einbringen eines Wärmeleitmediums,
- Figur 6: den Ausschnitt des Querschnitts des weiteren Steuergeräts nach dem Einbringen des Wärmeleitmediums,
- Figur 7: das Steuergerät mit einem langlochförmigen Gehäusedurchbruch und
- Figur 8: das Steuergerät mit mehreren kreisförmigen Gehäusedurchbrüchen.

### Ausführungsform(en) der Erfindung

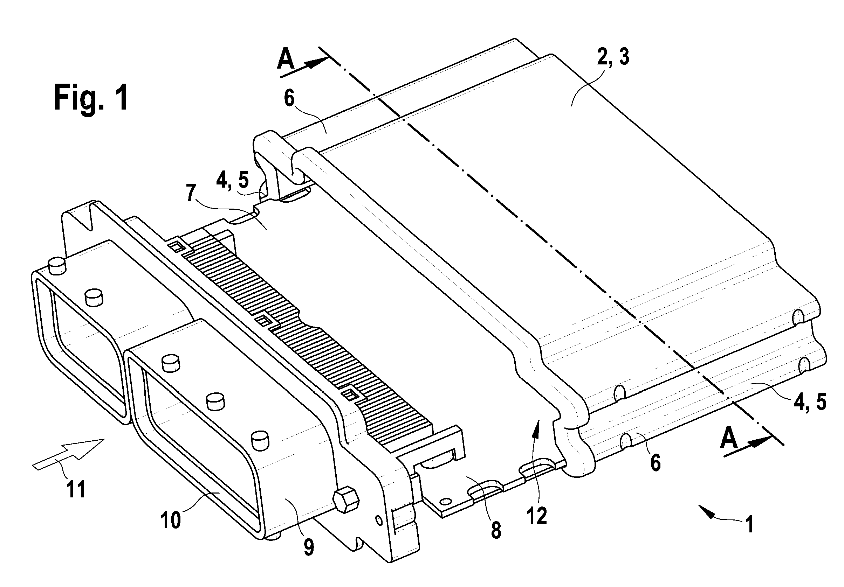

Die Figur 1 zeigt ein Steuergerät 1 eines nicht dargestellten Kraftfahrzeugs. Das Steuergerät 1 besitzt ein Gehäuse 2, welches als Einschubgehäuse 3 ausgeführt ist. Das Einschubgehäuse 3 ist aus Aluminium gefertigt, um eine Wärmeableitung zu ermöglichen. Ferner weist das Einschubgehäuse 3 zwei Führungen 4 auf, die sich in paralleler Richtung erstrecken. Die Führungen 4 sind als Führungsrinnen 5 ausgeführt, welche einen U-förmigen Querschnitt aufweisen, deren Öffnungen zueinander zeigen. Die Führungsrinnen 5 werden durch einen Abschnitt 6 des Gehäuses 2 gebildet. In das Einschubgehäuse 3 wird eine elektronische Baugruppe 7 eingeschoben. Die Baugruppe 7 ist als Leiterplatte 8 ausgeführt. Die Leiterplatte 8 ist mit einer Steckerkulisse 9 versehen, welche als Einschubgehäuseverschluss 10 dient. Die Leiterplatte 8 liegt bereichsweise in den Führungsrinnen 5, sodass die Leiterplatte 8 in Richtung eines Pfeils 11 in das Innere 12 des Gehäuses 2 einschiebbar ist.

Für eine Herstellung des fertigen Steuergeräts 1 wird die Leiterplatte 8 in das Innere 12 des Gehäuses 2 entlang der Richtung des Pfeils 11 eingeschoben. Dabei verschließt der Einschubgehäuseverschluss 10 das Einschubgehäuse 3.

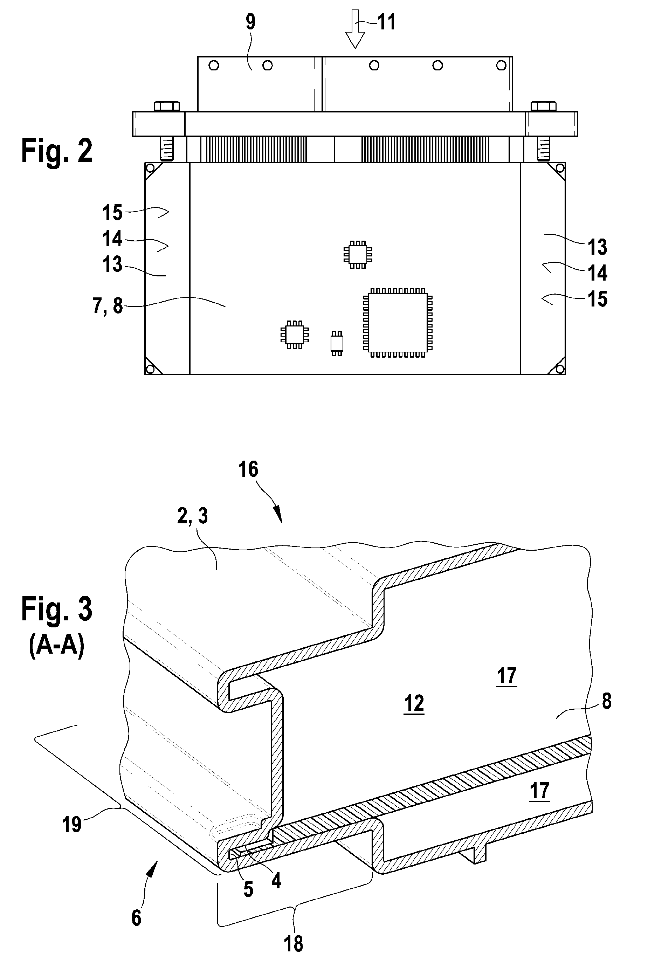

Die Figur 2 zeigt die elektronische Baugruppe 7 in Form der Leiterplatte 8 von einer in der Figur 1 nicht sichtbaren Seite. Die Leiterplatte 8 weist zwei Wärmeableitelemente 13. Die Wärmeableitelemente 13 sind als wärmeleitende Flächenstrukturen 14 ausgebildet, die jeweils eine große Kontaktfläche 15 aufweisen.

Die Figur 3 zeigt einen vereinfachten Ausschnitt 16 des Einschubgehäuses 3 mit eingeschobener Leiterplatte 8 im Querschnitt A-A, der in Figur 1 gezeigt ist. Die Leiterplatte 8 liegt somit im Inneren 12 des Gehäuses 2 und somit in einem Gehäuseinnenraum 17. Die Leiterplatte 8 liegt seitlich in der Führung 4, die als die Führungsrinne 5 ausgebildet ist. Dabei wird die Führungsrinne 5 von einem Abschnitt 6 des Einschubgehäuses 3 gebildet. Die Leiterplatte 8 steht mit dem Einschubgehäuse 3 in einem Wärmeableitbereich 18 in Berührkontakt. Daraus ergibt sich, dass die Führung 4 in einer Zone 19 des Wärmeableitbereichs 18 liegt.

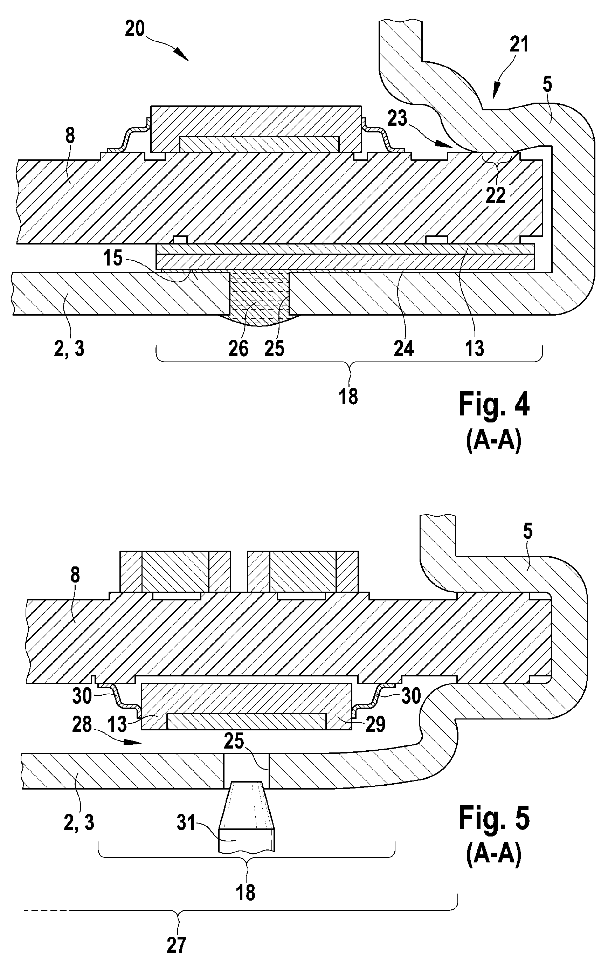

Die Figur 4 zeigt einen weiteren, vergrößerten Ausschnitt 20 entlang der Schnittlinie A-A aus Figur 1. Die Leiterplatte 8 liegt mit seiner Kontaktfläche 15 in Berührkontakt mit dem Einschubgehäuse 3. Dabei wird die Leiterplatte 8 in der Führungsrinne 5 geführt. Diese ist mit einer Einprägung 21 versehen, welche die Führungsrinne 5 bereichsweise auf die Leiterplatte 8 presst. Dabei entsteht ein Berührbereich 22 zwischen Leiterplatte 8 und Gehäuse 2. Dieser Berührbereich 22 weist einen Spaltraum 23 auf. Ferner ist zwischen der Kontaktfläche 15 und dem Einschubgehäuse 3 im Wärmeableitbereich 18 ein Spaltraum 24 vorhanden. Das Einschubgehäuse 3 weist einen Gehäusedurchbruch 25 auf, welcher sich von dem Spaltraum 24 aus durch das Einschubgehäuse 3 nach Außen erstreckt. In dem Gehäusedurchbruch 25 ist ein Wärmeleitmedium 26 eingebracht, welches den Spaltraum 24 sowie den Gehäusedurchbruch 25 ausfüllt und auf diese Weise eine wärmeleittechnische Verbindung schafft.

Die bei der Herstellung des Steuergeräts 1 herbeigeführte Einprägung 21 erzeugt einen festen Kontakt der Kontaktfläche 15 mit dem Einschubgehäuse 3 im Wärmeableitbereich 18. Da sich aufgrund von Fertigungstoleranzen die Spalträume 23 und 24 bilden, ist eine optimale Wärmeableitung an dieser Stelle nicht gegeben. Durch Auffüllen des Spaltraums 24 mit dem Wärmeleitmedium 26 kann die Wärmeableitung von dem Wärmeableitelement 13 über die Kontaktfläche 15 zum Einschubgehäuse 3 optimiert werden. Ferner ist es denkbar, dass auf analoge Weise der Spaltraum 23 mittels des Wärmeleitmediums 26 aufgefüllt wird. Es ist vorgesehen, dass es sich bei dem Wärmeleitmedium 26 um ein zumindest beim Einbringen pastöses Wärmeleitmedium 26 handelt. Eine pastöse Konsistenz des Wärmeleitmediums ermöglicht es, das Wärmeleitmedium 26 einfach durch den Gehäusedurchbruch 25 in den Gehäuseinnenraum 17 zwischen das Wärmeableitelement 13 und das Einschubgehäuse 3 einzubringen. Ein anschließendes Aushärten des Wärmeleitmediums 26 ist denkbar und hat die Vorteile, dass der Gehäusedurchbruch 25 dadurch abgedichtet wird und zusätzlich ein Halt für die Leiterplatte 8 herbeigeführt wird.

Die Figur 5 zeigt einen Ausschnitt eines Querschnitts einer weiteren Ausführungsform des Einschubgehäuses 3 im Querschnitt A-A. Das Einschubgehäuse 3 weist einen Bereich 27 auf, welcher gegenüber der Führungsrinne 5 abgesenkt ist. Dadurch ergibt sich, dass zwischen der Leiterplatte 8 und dem Gehäuse 2 ein sehr großer Spaltraum 28 entsteht. An der Leiterplatte 8 ist ein Wärmeableitelement 13 in Form eines Slug-Up-Elements 29 angebracht. Das Slug-Up-Element 29 ist wärmeleittechnisch mit der Leiterplatte 8 über Leiter 30 verbunden. Ferner ist das Slug-Up-Element 29 zwischen der Leiterplatte 8 und dem abgesenkten Bereich 27 des Einschubgehäuses 3 angeordnet. Somit bildet sich der Wärmeableitbereich 18 auch für das Slug-Up-Element 29 am Einschubgehäuse 3. Der Gehäusedurchbruch 25 befindet sich in einer Position, die relativ zum Slug-Up-Element 29 mittig angeordnet ist. An dem Gehäusedurchbruch 25 ist eine Dispensvorrichtung 31 gezeigt.

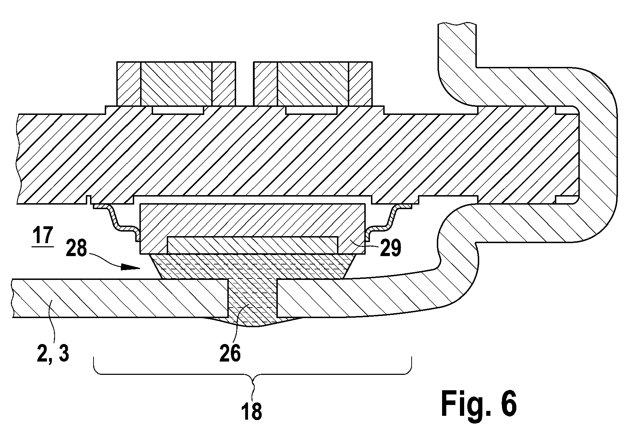

Die Figur 6 zeigt die Ausführungsform der Figur 5 mit all seinen Merkmalen. Im Unterschied zu Figur 5 ist zwischen Slug-Up-Element 29 und Einschubgehäuse 3 der Spaltraum 28 im Wärmeableitbereich 18 mittels des Wärmeleitmediums 26 ausgefüllt.

Das Wärmeleitmedium 26 wurde in einer pastösen Form über die Dispensvorrichtung 31 durch den Gehäusedurchbruch 26 in den Gehäuseinnenraum 17 eingebracht. Dabei verbindet das Wärmeleitmedium 26 das Slug-Up-Element 29 mit dem Einschubgehäuse 3. Um das Einschubgehäuse 3 an den Gehäusedurchbrüchen 26 abzudichten, härtet das Wärmeleitmedium 26 nach Einbringung aus. Auf die in Figur 6 dargestellte Weise ist eine sehr effiziente Wärmeableitung von der Leiterplatte 8 zum Einschubgehäuse 3 realisiert, wobei bei der Herstellung ein sehr einfaches Einbringen des Wärmeleitmediums 26 möglich ist.

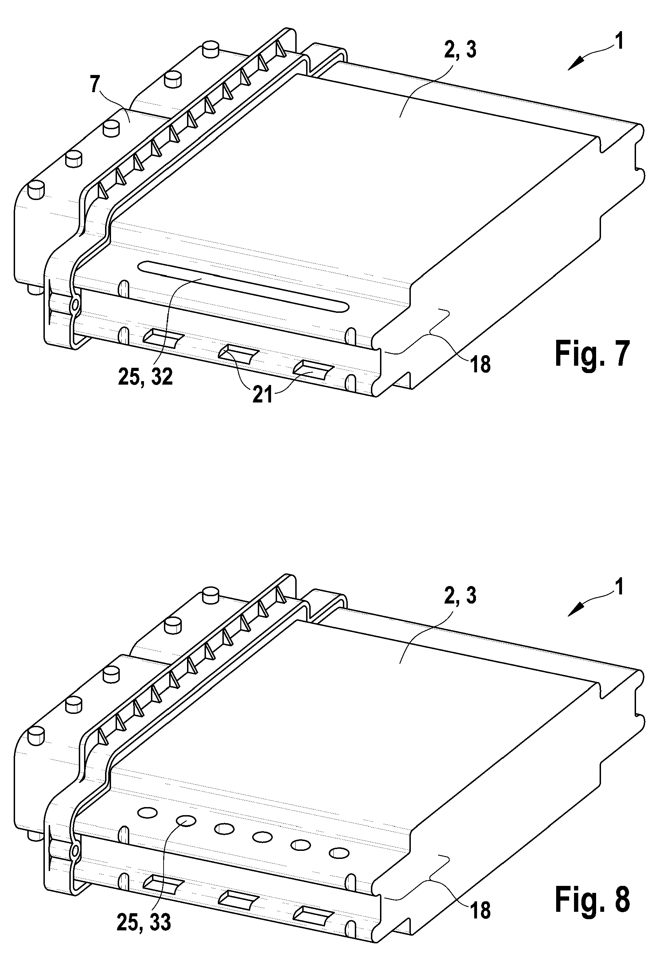

Die Figur 7 zeigt das Steuergerät 1 mit dem Einschubgehäuse 3 und eingeschobener Baugruppe 7. Im Wärmeableitbereich 18 ist der Gehäusedurchbruch 25 in Form eines Langlochs 32 dargestellt. Das Langloch 32 ermöglicht eine sehr einfache, schnelle und flächendeckende Einbringung des Wärmeleitmediums 26.

Figur 8 zeigt das Steuergerät 1 mit dem Einschubgehäuse 3, wobei im Wärmeableitbereich 18 eine Mehrzahl von Gehäusedurchbrüchen 25 angeordnet ist, die jeweils als kreisförmiger Gehäusedurchbruch 33 ausgeführt ist.

Mit der Erfindung ist ein Verfahren zur Herstellung des Steuergeräts 1 möglich, welches folgende Schritte umfasst:
- 1.: Bestückung der Leiterplatte 8 beispielsweise mit SMD-Bauteilen,
- 2.: Verlöten der SMD-Bauteile mit der Leiterplatte 8,
- 3.: Einschieben der Leiterplatte 8 in das Einschubgehäuse 3,
- 4.: Einbringen des Wärmeleitmediums 26 durch die Gehäusedurchbrüche 25 und
- 5.: Erzeugung der Einprägungen 21 am Gehäuse 2 im Bereich der Führungsrinnen 5.

## Patentansprüche

1. Steuergerät (1), insbesondere für ein Kraftfahrzeug, wobei das Steuergerät (1) ein mindestens einen Wärmeableitbereich (18) aufweisendes Gehäuse (2) besitzt, in dem mindestens eine elektrische und/oder elektronische Baugruppe (7) angeordnet ist, die mindestens ein Wärmeableitelement (13) aufweist, wobei das Wärmeableitelement (13) mit dem Wärmeableitbereich (18) mittels eines in das Innere (12) des Gehäuses (2) durch mindestens einen Gehäusedurchbruch (25) eingebrachtes, zumindest beim Einbringen pastöses Wärmeleitmedium (26) wärmeleittechnisch verbunden ist,
**dadurch gekennzeichnet,**
**dass** das Gehäuse (2) ein Einschubgehäuse (3) ist, in das die Baugruppe (7) eingeschoben ist,
**dass** das Gehäuse (2) für das Einschieben der Baugruppe (7) eine Führung (4) aufweist, wobei die Führung (4) als Führungsrinne (5) ausgebildet ist, wobei sich das Wärmeableitelement (13) bis in die Führung (4) erstreckt, und dass die Führungsrinne (5) mit mindestens einer Einprägung (21) zum randseitigen Einklemmen der Baugruppe (7) versehen ist.

2. Steuergerät (1) nach Anspruch 1, **dadurch gekennzeichnet, dass** das Wärmeleitmedium (26) einen zwischen dem Wärmeableitelement (13) und dem Wärmeableitbereich (18) liegenden, einen Anteil des freien Gehäuseinnenraums (17) bildenden Spaltraum (28) ausfüllt.

3. Steuergerät (1) nach einem oder mehreren der vorhergehenden Ansprüche, **dadurch gekennzeichnet, dass** die Führung (4) in einer Zone (19) des Wärmeableitbereichs (18) liegt.

4. Steuergerät (1) nach einem oder mehreren der vorhergehenden Ansprüche, **dadurch gekennzeichnet, dass** ein Abschnitt (6) des Gehäuses (2) die Führungsrinne (5) bildet.

5. Steuergerät (1) nach einem oder mehreren der vorhergehenden Ansprüche, **dadurch gekennzeichnet, dass** die Baugruppe (7) eine Leiterplatte (8) aufweist, die in der Führungsrinne (5) aufgenommen wird.

6. Verfahren zur Herstellung eines Steuergeräts (1), insbesondere für ein Kraftfahrzeug, insbesondere nach einem oder mehreren der vorhergehenden Ansprüche, wobei das Steuergerät (1) ein mindestens einen Wärmeableitbereich (18) aufweisendes Gehäuse (2) besitzt, in dem mindestens eine elektrische und/oder elektronische Baugruppe (7) angeordnet ist, die mindestens ein Wärmeableitelement (13) aufweist, wobei das Wärmeableitelement (13) mit dem Wärmeableitbereich (18) mittels eines in das Innere (12) des Gehäuses (2) durch mindestens einen Gehäusedurchbruch (25) eingebrachtes, zumindest beim Einbringen pastöses Wärmeleitmedium (26) wärmeleittechnisch verbunden wird,
**dadurch gekennzeichnet, dass**
das Gehäuse als Einschubgehäuse (3) ausgebildet ist,
wobei das Gehäuse (2) für das Einschieben der Baugruppe (7) eine Führung (4) aufweist,
wobei die Führung (4) als Führungsrinne (5) ausgebildet ist und wobei durch Einprägen der Führungsrinne (5) die Baugruppe (7) innerhalb der Führungsrinne (5) eingeklemmt und fixiert wird.

## Claims

1. Control unit (1), in particular for a motor vehicle, wherein the control unit (1) has a housing (2) which has at least one heat dissipation region (18) and in which at least one electrical and/or electronic module (7) which has at least one heat dissipation element (13) is arranged, wherein the heat dissipation element (13) is connected in a heat-conducting fashion to the heat dissipation region (18) by means of a heat-conducting medium (26) which is introduced into the interior (12) of the housing (2) through at least one housing breakthrough (25) and is at least pasty while the introduction process takes place,
**characterized**
**in that** the housing (2) is a rack housing (3) into which the module (7) is inserted,
**in that** the housing (2) has a guide (4) for the insertion of the module (7), wherein the guide (4) is embodied as a guide groove (5), wherein the heat-conducting element (13) extends into the guide (4), and in that the guide groove (5) is provided with at least one impressed region (21) for edge-side clamping in of the module (7).

2. Control unit (1) according to Claim 1, **characterized in that** the heat-conducting medium (26) fills a gap space (28) which is located between the heat dissipation element (13) and the heat dissipation region (18) and forms a portion of the free interior (17) of the housing.

3. Control unit (1) according to one or more of the preceding claims, **characterized in that** the guide (4) is located in a zone (19) of the heat dissipation region (18).

4. Control unit (1) according to one or more of the preceding claims, **characterized in that** a section (6) of the housing (2) forms the guide groove (5).

5. Control unit (1) according to one or more of the preceding claims, **characterized in that** the module (7) has a circuit board (8) which is accommodated in the guide groove (5).

6. Method for manufacturing a control unit (1), in particular for a motor vehicle, in particular according to one or more of the preceding claims, wherein the control unit (1) has a housing (2) which has at least one heat dissipation region (18) and in which at least one electrical and/or electronic module (7) which has at least one heat dissipation element (13) is arranged, wherein the heat dissipation element (13) is connected in a heat-conducting fashion to the heat dissipation region (18) by means of a heat-conducting medium (26) which is introduced into the interior (12) of the housing (2) through at least one housing breakthrough (25) and is at least pasty while the introduction process takes place,
**characterized**
**in that** the housing is embodied as a rack housing (3),
wherein the housing (2) has a guide (4) for the insertion of the module(7),
wherein the guide (4) is embodied as a guide groove (5), and wherein the module (7) is clamped in and secured within the guide groove (5) by impressing the guide groove (5).

## Revendications

1. Appareil de commande (1), notamment pour un véhicule automobile, l'appareil de commande (1) possédant un boîtier (2) présentant au moins une région de dissipation de la chaleur (18), dans lequel est disposé au moins un module électrique et/ou électronique (7) qui présente au moins un élément de dissipation de la chaleur (13), l'élément de dissipation de la chaleur (13) étant connecté par une technique de conduction thermique à la région de dissipation de la chaleur (18) au moyen d'un milieu de conduction thermique (26) pâteux au moins lors de son introduction, introduit à l'intérieur (12) du boîtier (2) à travers au moins une orifice du boîtier (25),
**caractérisé en ce que**
le boîtier (2) est un boîtier d'insertion (3) dans lequel est inséré le module (7),
le boîtier (2) présente un guide (4) pour l'insertion du module (7), le guide (4) étant réalisé sous la forme d'une rainure de guidage (5), l'élément de dissipation de la chaleur (13) s'étendant jusque dans le guide (4) et la rainure de guidage (5) étant pourvue d'au moins une impression (21) pour le serrage du module (7) au niveau des bords.

2. Appareil de commande (1) selon la revendication 1, **caractérisé en ce que** le milieu de conduction thermique (26) remplit un espace d'interstice (28) situé entre l'élément de dissipation de la chaleur (13) et la région de dissipation de la chaleur (18), formant une partie de l'espace interne libre du boîtier (17).

3. Appareil de commande (1) selon l'une quelconque ou plusieurs des revendications précédentes, **caractérisé en ce que** le guide (4) est situé dans une zone (19) de la région de dissipation de la chaleur (18).

4. Appareil de commande (1) selon l'une quelconque ou plusieurs des revendications précédentes, **caractérisé en ce qu'**une section (6) du boîtier (2) forme la rainure de guidage (5).

5. Appareil de commande (1) selon l'une quelconque ou plusieurs des revendications précédentes, **caractérisé en ce que** le module (7) présente une carte à circuits imprimés (8) qui est reçue dans la rainure de guidage (5).

6. Procédé de fabrication d'un appareil de commande (1), notamment pour un véhicule automobile, en particulier selon l'une quelconque ou plusieurs des revendications précédentes, dans lequel l'appareil de commande (1) possède un boîtier (2) présentant au moins une région de dissipation de la chaleur (18), dans lequel est disposé au moins un module électrique et/ou électronique (7) qui présente au moins un élément de dissipation de la chaleur (13), l'élément de dissipation de la chaleur (13) étant connecté par une technique de conduction thermique à la région de dissipation de la chaleur (18) au moyen d'un milieu de conduction thermique (26) pâteux au moins lors de son introduction, introduit à l'intérieur (12) du boîtier (2) à travers au moins une orifice du boîtier (25),
**caractérisé en ce que**
le boîtier est réalisé sous forme de boîtier d'insertion (3),
le boîtier (2) présentant un guide (4) pour l'insertion du module (7),
le guide (4) étant réalisé sous la forme d'une rainure de guidage (5), le module (7) étant serré et fixé à l'intérieur de la rainure de guidage (5) par impression de la rainure de guidage (5).
